# FASCICULE DE BREVET EUROPEEN

(11) **EP 4 264 302 B1**
(45) Date de publication et mention de la délivrance du brevet: **18.02.2026**
(21) Numéro de dépôt: 21848279.2
(22) Date de dépôt: 16.12.2021
(51) Int. Cl.: G01R 31/392, H02J 7/00, G01R 31/396, G01R 31/371, G01R 31/374, G01R 31/3842

(54) **PROCEDE ET DISPOSITIF DE DETERMINATION DE L'ETAT DE SANTE D'UNE BATTERIE D'UN VEHICULE ELECTRIQUE**
VERFAHREN UND VORRICHTUNG ZUR BESTIMMUNG DES GESUNDHEITSZUSTANDS EINER BATTERIE EINES ELEKTROFAHRZEUGS
METHOD AND DEVICE FOR DETERMINING THE STATE OF HEALTH OF A BATTERY OF AN ELECTRIC VEHICLE

(30) Priorité: 18.12.2020 FR 2013672; 18.12.2020 FR 2013678
(43) Date de publication de la demande: 25.10.2023
(73) Titulaire: Electricité de France, 75008 Paris (FR)
(72) Inventeur: TORCHEUX, Laurent, 91330 Yerres (FR); LHERMENAULT, Julien, 77780 Bourron-Marlotte (FR); VICENTE, Jean Louis, 77130 La Grande Paroisse (FR); LASSERRE, Bertrand, 77300 Fontainebleau (FR); GUYOT, Renaud, 92800 Puteaux (FR)
(74) Mandataire: Regimbeau
(86) Numéro de dépôt international: PCT/FR2021/052351
(87) Numéro de publication internationale: WO 2022/129794

(56) Documents cités:
- EP-A1- 3 686 618
- EP-A1- 3 751 296
- EP-A2- 2 837 522
- GB-A- 2 537 612
- US-A1- 2004 169 489
- US-A1- 2005 231 205
- US-A1- 2007 239 374
- US-A1- 2017 331 162
- US-A1- 2020 003 839

## Description

### DOMAINE DE L'INVENTION

Le domaine de l'invention est celui des véhicules électriques. L'invention concerne plus particulièrement la détermination de l'état de santé d'une batterie d'un véhicule électrique.

### ETAT DE LA TECHNIQUE

L'invention concerne le domaine des véhicules électriques et/ou des véhicules hybrides rechargeables.

Dans les deux cas, ces véhicules sont alimentés, au moins en partie, par une batterie électrique fournissant l'énergie nécessaire au déplacement du véhicule.

Pour fonctionner, la batterie doit être régulièrement rechargée.

### Les différents modes de recharge

La série de normes internationales 61851 (dédiée à la recharge des véhicules électriques) définissent quatre modes de recharge adaptés à une recharge de quelques kilowatts sur une prise domestique chez le particulier jusqu'à une recharge très forte, puissante de plusieurs centaines de kilowatts, destinée aux grands axes routiers.

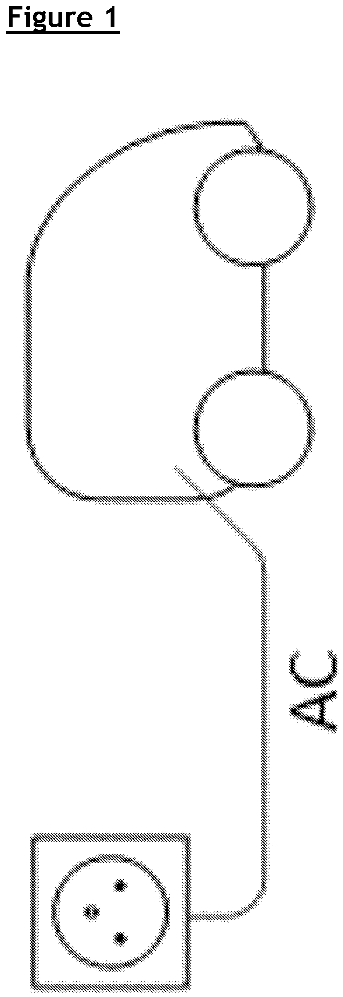

Ces modes de recharges sont schématisés sur les figures 1 à 4.

En référence à la figure 1, un premier mode consiste uniquement en une recharge en courant alternatif (AC) sur une prise secteur domestique. Dans ce mode de recharge, aucun contrôle de sécurité n'est opéré sur l'alimentation électrique.

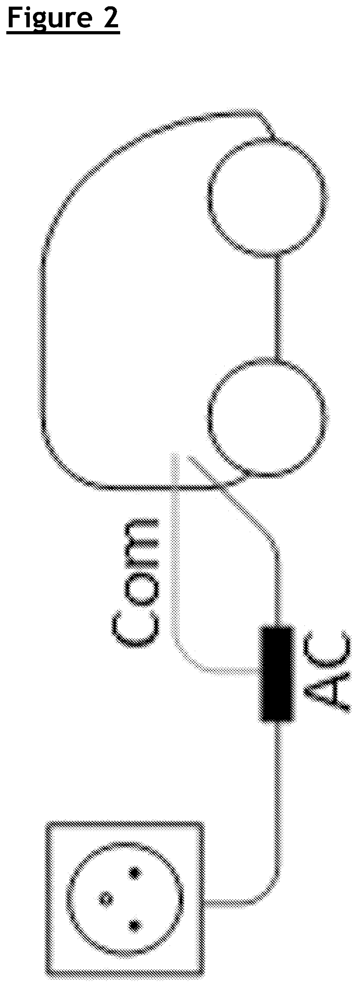

En référence à la figure 2, un deuxième mode consiste en une recharge en courant alternatif (AC) sur une prise secteur domestique. Dans ce mode, le câble de charge est équipé d'un boitier de contrôle permettant de communiquer sur la sécurité électrique et la puissance de charge disponible. Ce mode fonctionne jusqu'à une puissance maximum de 7,2kW.

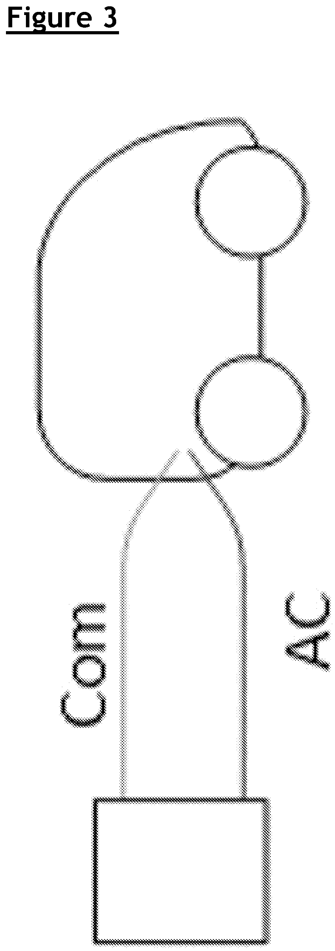

En référence à la figure 3, un troisième mode de recharge concerne une recharge en courant alternatif (AC) sur un coffret d'alimentation dédié. Dans cette configuration le coffret d'alimentation dédié permet d'alimenter la batterie et permet de communiquer sur la sécurité électrique et la puissance de charge disponible. En général ce mode ne peut fonctionner que jusqu'à une puissance maximum de 7 ,2 kW en monophasé (32 A/phase) et 22 kW en triphasé (32 A/phase) avec un cordon de charge mobile et 43 kW (63 A/phase) avec un cordon fixé à la borne de charge.

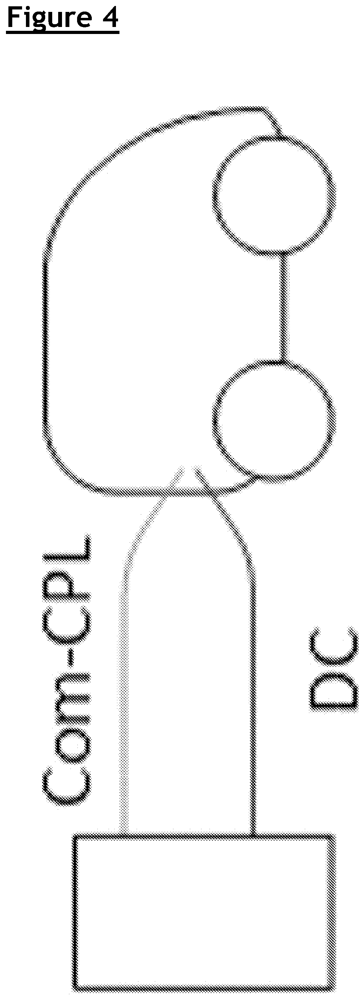

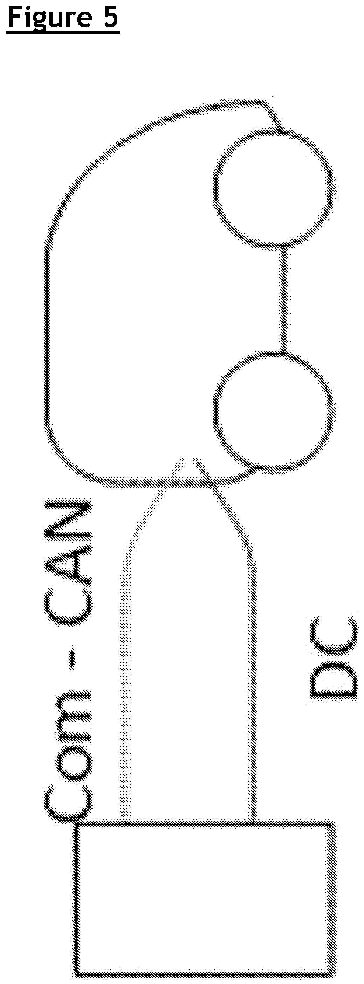

En référence aux figures 4 et 5, selon un quatrième mode, le véhicule est chargé en courant continu (DC) sur un coffret dédié. Ce mode permet une communication fonctionnelle et sécuritaire entre le coffret d'alimentation et le véhicule. Aujourd'hui, ce mode ne peut fonctionner que jusqu'à une puissance maximum de 350kW. On distingue deux technologies majeures fonctionnant selon ce mode : la technologie « Combo CCS » (figure 4) et la technologie « CHAdeMO » (figure 5).

### Différents types de prises de recharge côté véhicule

Outre, les modes de recharge, les prises de recharges varient elles aussi en fonction des technologies choisies par les constructeurs automobiles.

La norme IEC 62196-2 définit différentes variantes de prises et socles pour les câbles et les équipements de recharge conductive et les véhicules électriques.

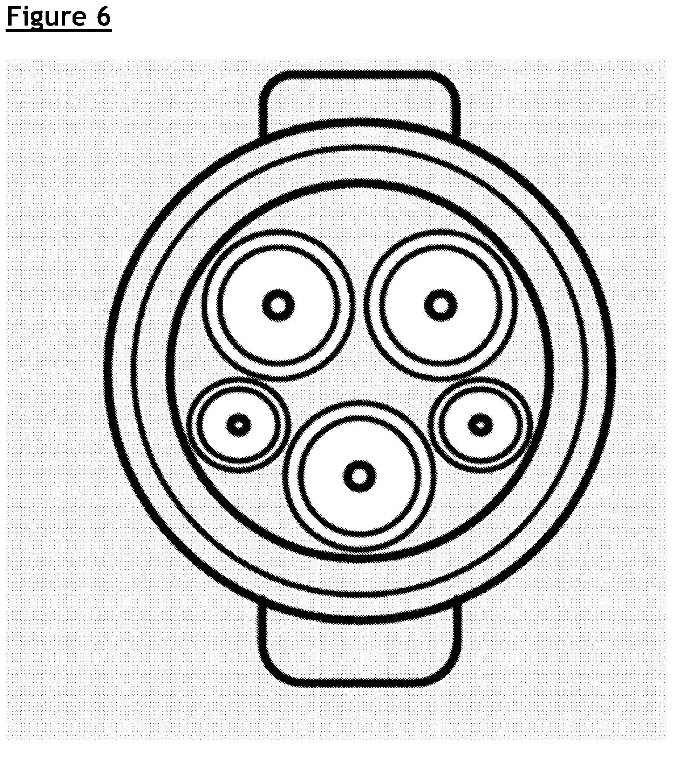

On distingue quatre types principaux de prises/socles côté véhicule, représentés sur les figures 6 à 9.

En référence à la figure 6, un premier type concerne les prises/socles pour courant alternatif. Ces prises acceptent une tension maximale de 250V et un courant maximal de 32A, ce qui correspond à une puissance électrique maximale de 7,2kW. Ces prises sont adaptées pour le deuxième mode de recharge, et dans une moindre mesure pour le troisième mode de recharge (prise limitée à la charge monophasée).

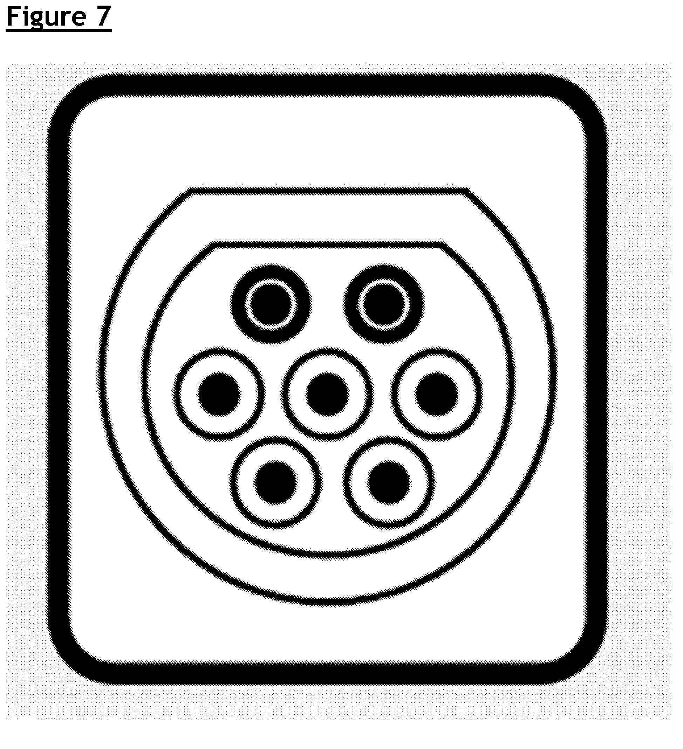

En référence à la figure 7, un deuxième type de prises/socles concerne les prises/socles pour courant alternatif. Ces prises acceptent une tension maximale de 500V et un courant maximal de 63A, ce qui correspond à une puissance électrique maximale de 43kW. Ces prises sont adaptées pour le deuxième mode de recharge et pour le troisième mode de recharge. Ces prises/socles supportent les charges monophasées et/ou triphasées.

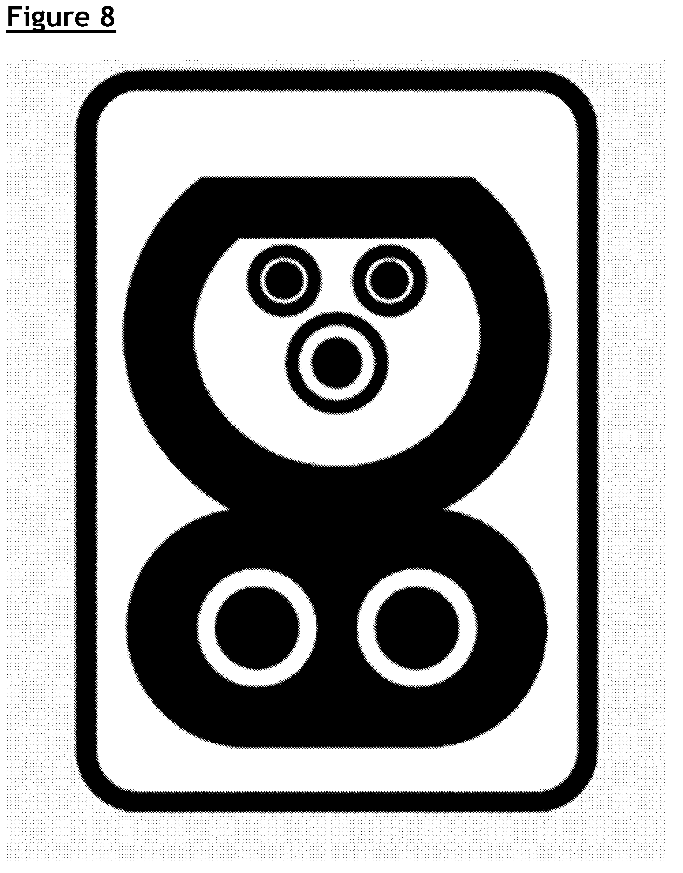

En référence à la figure 8, un troisième type de prises/socles concerne les prises/socles les charges à courant continu (DC) du type « COMBO CCS ». Ces prises acceptent une tension maximale de 1000V et un courant maximal de 500A. Aujourd'hui, la puissance électrique maximum de charge constatée est de 350 kW et les puissances usuelles sont comprises entre 50 et 150 kW. Ces prises sont adaptées pour le quatrième mode de recharge dans une configuration de type « COMBO CCS ».

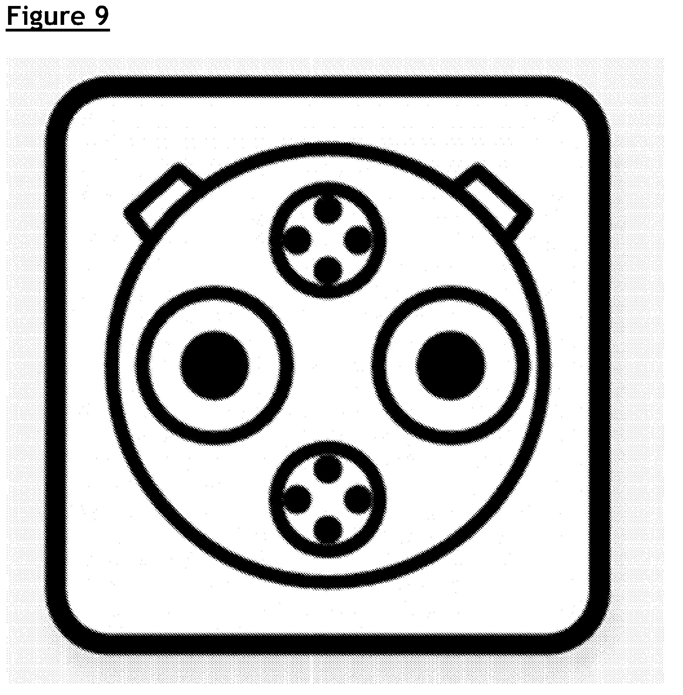

En référence à la figure 9, un quatrième type de prises/socles concerne les prises/socles pour courant continu du type « CHAdeMO ». Ces prises acceptent une tension maximale de 1000V et un courant maximal de 400A. Aujourd'hui la puissance maximum de charge constatée est de 350 kW et les puissances usuelles sont comprises entre 50 et 150 kW. Ces prises sont adaptées pour le quatrième mode de recharge dans une configuration de type « CHAdeMO ».

Il est notable que depuis quelques années, la prise de deuxième type (charge mono et triphasée pour une puissance de charge jusqu'à 43 kW) s'impose au niveau mondial au détriment de la prise de premier type (limitée à une charge monophasée et une puissance de charge de 7,2 kW).

L'Europe a retenu, en charge AC, la prise/socle de deuxième type et en charge DC, la prise/socle COMBO CCS 2. Cependant, les véhicules CHAdeMO sont très présents en Europe d'où une présence très importante de ces systèmes de charge sur les axes routiers.

### Contexte - Différents types de prises de recharge côté équipement d'alimentation et véhicule électrique

En fonction du mode de recharge choisi mais aussi de choix technologiques propres à chaque constructeur, il existe aussi plusieurs types de prises/socles côté équipement d'alimentation.

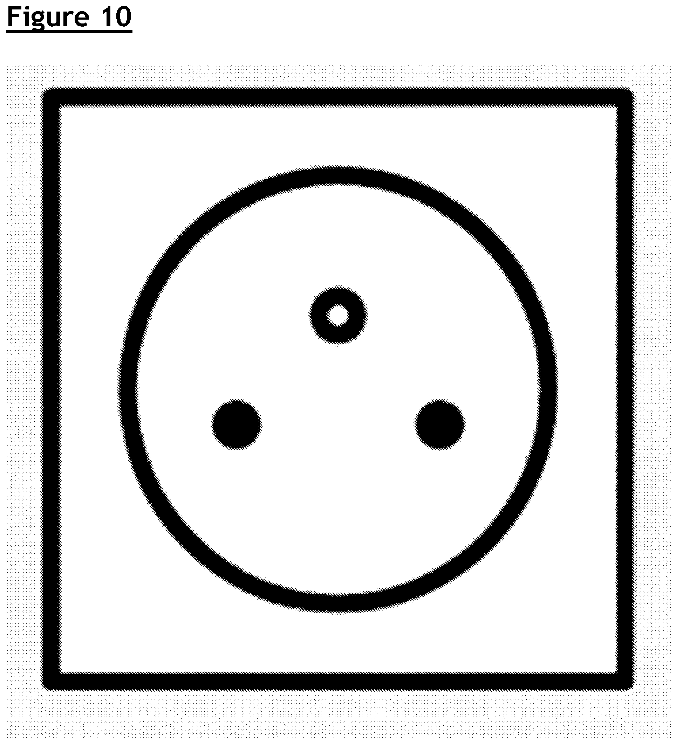

En référence à la figure 10, un premier type de prise/socle est la prise domestique classique. La plupart des véhicules peuvent être rechargés sur une telle prise. Cependant, elle ne fournit une puissance maximale que de 2 ou 3 kW. Ce type de prise/socle est adapté pour le deuxième mode de charge.

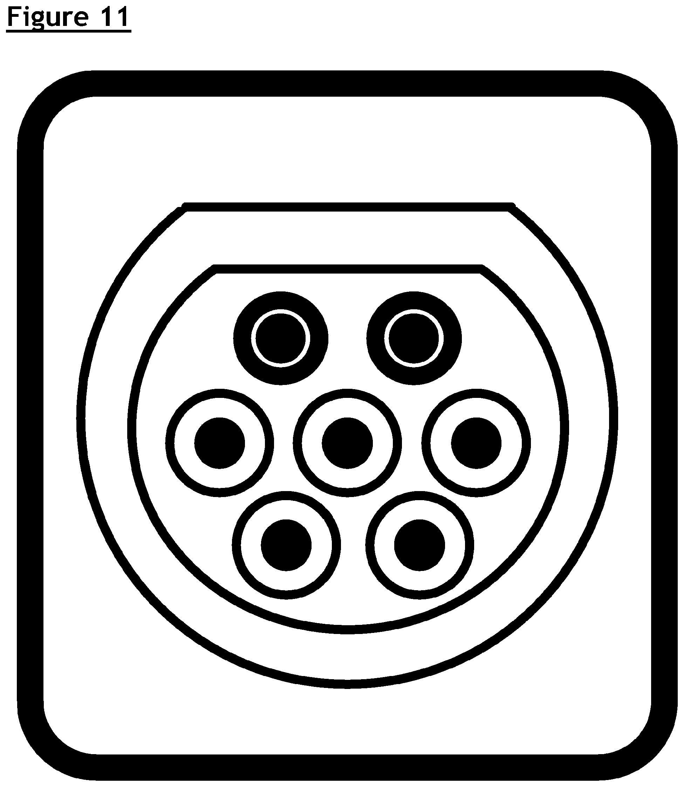

Un deuxième type de prise/socle est présenté sur la figure 11. Ce type de prise/socle autorise une puissance maximale de 22kW en courant triphasé et est adapté pour le troisième mode de recharge.

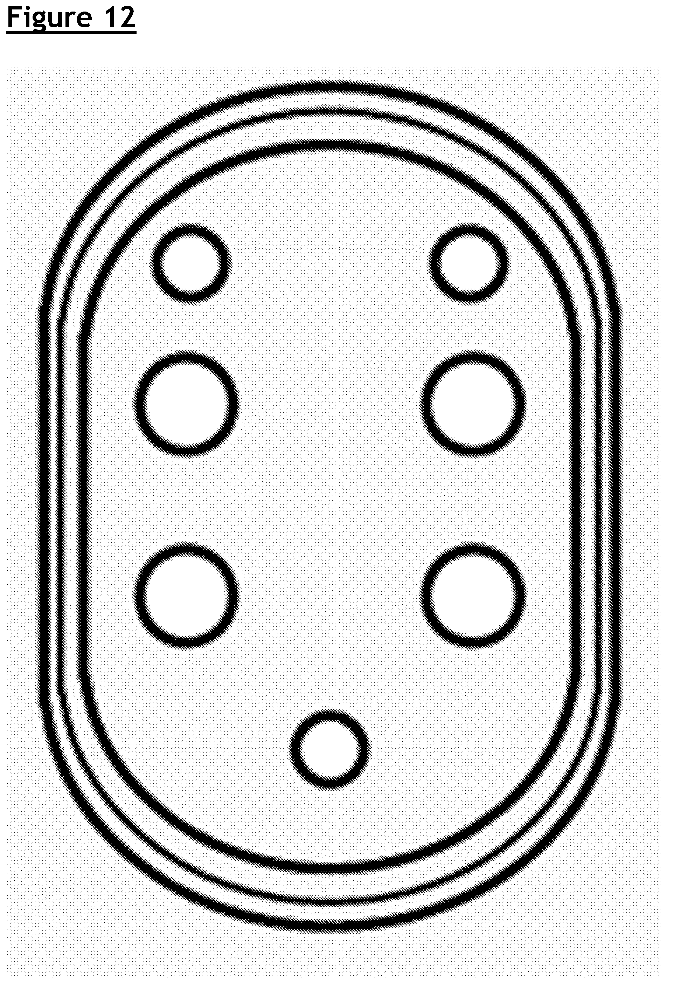

Un troisième type de prise/socle est présenté en figure 12. Ce type de prise/socle autorise une puissance maximale de 22kW en courant triphasé et est adapté pour le troisième mode de recharge.

On comprend donc que le marché des véhicules électriques ou hybrides rechargeable présente un grand nombre de standards dans le domaine de la recharge. Ainsi il existe une pluralité de technologie de rechargement et une pluralité d'architectures de prises/socles. Ce grand nombre de structures différentes ne favorise pas la création d'équipements standards adaptables sur n'importe quel véhicule ou borne de recharge.

### Besoin de détermination de l'état de santé de la batterie

Par ailleurs, depuis la mise sur le marché des véhicules électriques utilisant la technologie des batteries lithium-ion il y a plus de 10 ans (iMiev^{®} de Mitsubishi^{®} en 2009, Renault Zoé^{®} en 2012, ...), un marché de l'occasion s'est naturellement développé.

Ce marché va se renforcer avec l'augmentation sensible du nombre de véhicules électriques dans le parc français. Tous les constructeurs présentent plusieurs modèles électriques (100% ou hybride rechargeable). D'après les études d'experts, leur nombre pourrait atteindre en France 11 millions en 2035.

Le point essentiel lors de l'achat d'un véhicule électrique d'occasion est la connaissance de l'état de santé réel de la batterie. Ce paramètre permet de définir la durée de vie restante de la batterie, qui constitue un composant essentiel de la valeur du véhicule électrique.

Le vieillissement d'une batterie se traduit par une perte d'autonomie du véhicule (nombre de kilomètres réalisés pour une charge complète) et une diminution du nombre de cycles de charges/décharges complètes.

Le vieillissement est dû, d'une part, à des phénomènes naturels liés à la chimie, d'autre part, aux conditions d'usages et d'utilisations, tels que le courant de charge/décharge, la température pendant les phases de charge, la profondeur de décharge, etc., qui peuvent avoir un impact important sur la durée de vie de la batterie. Par conséquent, deux batteries équivalentes peuvent avoir des durées de vie très différentes.

### Méthodes actuelles d'évaluation de l'état de santé d'une batterie

Aujourd'hui, les utilisateurs de véhicules électriques n'ont aucun moyen de connaître l'état de santé réelle de la batterie du véhicule. Ils disposent uniquement d'un affichage de l'autonomie sur le tableau de bord exprimé en pourcentage ou en kilomètres.

Cette information présente plusieurs défauts :
- L'autonomie affichée dépend directement des habitudes de conduite du conducteur (accélération, freinage, anticipation, route sinueuse, ville...). Cet affichage d'autonomie prédictif est instable et il varie fortement d'un conducteur à un autre. Il ne reflète pas ou peu l'autonomie résiduelle réelle de la batterie par rapport à une mesure normalisée (telle qu'une mesure obtenue selon « la procédure d'essai mondiale harmonisée pour les voitures particulières et véhicules utilitaires légers » ou « WLTP » par exemple).
- Cette autonomie est calculée à partir d'algorithmes différents d'un constructeur à un autre, ces algorithmes ne sont pas toujours précis ; ils peuvent dériver ou même, ils pourraient être manipulables à des fins commerciales.

Pour plusieurs modèles de véhicules électriques mis sur le marché au début des années 2010, il peut y avoir un écart de 60% entre l'autonomie affichée au tableau de bord après une charge complète et le kilométrage réellement réalisé.

Par ailleurs, certaines entreprises proposent un diagnostic de la batterie, à partir des données constructeurs disponibles sur la prise OBD2 du véhicule. Cette méthode présente deux inconvénients. Le premier inconvénient est l'utilisation de données constructeurs dont on ne connait pas la fiabilité. Le deuxième inconvénient concerne la disponibilité des données nécessaires sur la prise OBD2 pour évaluer l'état de santé de la batterie. Cette disponibilité dépend uniquement du bon vouloir des constructeurs de véhicule qui n'ont aucune obligation réglementaire de mettre à disposition ces informations. Par conséquent cette méthode n'est pas applicable à tous les véhicules électriques, et actuellement, les entreprises proposent ce service uniquement sur certains véhicules électriques.

### Conséquences du manque de fiabilité de la connaissance de l'état de santé de la batterie

La faible fiabilité de cette information et la méconnaissance de l'état de santé de la batterie peuvent induire en erreur le potentiel acheteur et conduire à de fortes déceptions.

Cela peut conduire les utilisateurs à l'impossibilité d'utiliser le véhicule dû à une autonomie trop faible pour l'application prévue et à devoir, soit renoncer à utiliser leur véhicule, soit à s'équiper d'une nouvelle batterie quelque temps après l'achat. Il est important de noter que la batterie est l'élément crucial le plus cher du véhicule (plusieurs milliers d'euros, lorsque la batterie n'est plus sous garantie), d'où l'importance de connaître l'état de santé réel de la batterie avant l'achat.

Si ce genre de difficultés devait se généraliser, cela créerait un climat de forte défiance sur le marché des véhicules électriques d'occasion.

Afin d'éviter que l'achat d'une voiture électrique d'occasion devienne un acte risqué, il est possible de mettre en œuvre une méthode de certification de l'état de santé de n'importe quel véhicule électrique à partir d'une mesure de paramètres électriques de la batterie.

Dans ce contexte, il existe un important besoin pour des dispositifs, indépendants des constructeurs automobiles, qui permettraient de quantifier l'état de santé des batteries de motorisation embarquées des véhicules électriques.

GB 2 537 612 A2 décrit un dispositif de surveillance d'une batterie. Ce dispositif comprend un circuit de surveillance pour surveiller les signaux indiquant une sortie de la batterie, le circuit de surveillance étant capable de capturer les signaux pendant au moins une partie d'un cycle de démarrage déclenché par un événement d'allumage, et un circuit de transmission capable de transmettre des données indiquant les signaux surveillés vers un dispositif d'analyse qui est éloigné du véhicule. Le dispositif de surveillance peut se connecter à une prise de diagnostic du véhicule et communiquer sans fil avec l'analyseur distant. L'analyseur peut utiliser les prévisions météorologiques ou de température pour prédire la défaillance de la batterie, et peut communiquer avec l'utilisateur d'un véhicule pour fournir une indication sur l'état de la batterie.

US 2020/003839 A1 divulgue un dispositif pour évaluer l'état de santé d'une batterie qui comprend un calculateur de valeur de caractéristique et un évaluateur de dégradation qui exploite la valeur de caractéristique calculée.

US 2007/239374 A1, US 2005/231205 A1, US 2017/331162 A1, EP 3 686 618 A1, EP 2 837 522 A2, US 2004/169489 A1 et EP 3 751 296 Al divulguent des procédés et dispositifs alternatifs de détermination de l'état de santé d'une batterie.

### EXPOSE DE L'INVENTION

L'invention porte sur un procédé, selon la revendication 1, et sur un dispositif de détermination de l'état de santé d'une batterie d'un véhicule électrique, selon la revendication 13. Le dispositif comprend des organes de mesure lors d'une charge / décharge de grandeurs électriques et/ou physiques de la batterie et une unité de traitement configurée pour mettre en œuvre le procédé. Le dispositif peut en outre comprendre des connecteurs à une prise de service plug du véhicule ou à un organe de charge de la batterie.

Les grandeurs électriques mesurées peuvent comprendre une tension électrique aux bornes de la batterie, ou un courant électrique circulant dans la batterie.

Les grandeurs physiques mesurées peuvent comprendre une température de la batterie.

Les organes de mesure peuvent comprendre au moins deux connecteurs électriques, un capteur de courant électrique, un capteur de tension électrique et l'unité de traitement configurée pour déterminer un état de santé de la batterie à partir des grandeurs électriques mesurées.

Les organes de mesure peuvent comprendre un capteur de température de la batterie ledit capteur de température étant relié à l'unité de traitement.

Le dispositif peut comprendre une interface homme-machine, pour afficher des grandeurs électriques mesurées et l'état de santé déterminé de la batterie.

L'interface homme-machine peut comprendre au moins un écran permettant d'afficher un résultat d'une mesure opérée par au moins un organe de mesure.

L'interface homme-machine peut comprendre un clavier permettant de piloter le dispositif.

Le dispositif peut comprendre un émetteur récepteur sans fil, qui est préférentiellement un émetteur récepteur Wifi et/ou un émetteur récepteur Bluetooth.

Le dispositif peut comprendre un fusible interposé entre l'un des connecteurs électriques et le capteur de tension, le fusible permettant de protéger le dispositif d'un court-circuit.

L'invention s'étend également à une prise de service plug pour véhicule électrique, selon la revendication 14, la prise comprenant un socle relié d'un côté à une batterie du véhicule électrique et de l'autre coté à une partie utilisation du véhicule électrique, une prise manipulable par un opérateur qui permet d'isoler électriquement la batterie, la prise de service plug comprenant en outre un dispositif selon l'invention.

L'invention s'étend également à un câble de charge de véhicule électrique, selon la revendication 15, le câble comprenant un dispositif selon l'invention ainsi qu'à une borne de charge de véhicule électrique comprenant un dispositif selon l'invention.

Les grandeurs physiques et électriques de la batterie mesurées à l'étape (a) du procédé selon la revendication 1 peuvent être choisies parmi la tension, le courant et la température, ou une combinaison de ces grandeurs.

L'étape (a) peut comprendre une estimation d'une température interne de la batterie en utilisant un modèle thermique et une mesure de température.

L'étape (a) peut comprendre une détermination d'un état de charge apparent de la batterie par traitement d'une tension mesurée et de la température interne estimée.

Les grandeurs physiques et électriques de la batterie mesurées à l'étape (b) du procédé selon la revendication 1 peuvent être choisies parmi la tension, le courant et la température, ou une combinaison de ces grandeurs.

L'étape (b) peut comprendre une estimation d'une distribution de la température interne de la batterie en utilisant un modèle thermique et une mesure de température.

L'étape (b) peut comprendre un recalage de l'ensemble des mesures par rapport à la distribution de température estimée.

L'étape (b) peut comprendre un calcul d'une résistance apparente de la batterie.

L'étape (b) peut comprendre une estimation d'une distribution statistique connaissant une résistance théorique de la batterie lorsque son état de santé est à 100% et connaissant la résistance apparente calculée.

Si la batterie comprend plusieurs cellules, l'étape (b) peut comprendre le calcul de paramètres de tension, de courant et de résistance interne pour chaque cellule, pour obtenir une distribution statistique par cellule.

L'état de charge peut être calculé par intégration coulométrique.

Le procédé selon la revendication 1 peut comprendre une étape (e) intermédiaire des étapes (d) et (f), l'étape (e) comprenant un calcul de distributions statistiques de l'état de santé de chaque cellule de la batterie, à partir de la distribution statistique par cellule des paramètres de tension.

L'étape (f) peut être réalisée en utilisant les distributions statistiques des états de santé de chaque cellule déterminées à l'étape (e), et en utilisant une configuration électrique connue de la batterie.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :
La figure 1, précédemment présentée, est un schéma de principe d'un premier mode de recharge d'un véhicule électrique.
La figure 2, précédemment présentée, est un schéma de principe d'un deuxième mode de recharge d'un véhicule électrique.
La figure 3, précédemment présentée, est un schéma de principe d'un troisième mode de recharge d'un véhicule électrique.
La figure 4, précédemment présentée, est un schéma de principe d'une première alternative d'un quatrième mode de recharge d'un véhicule électrique.
La figure 5, précédemment présentée, est un schéma de principe d'une deuxième alternative d'un quatrième mode de recharge d'un véhicule électrique.
La figure 6, précédemment présentée, est un schéma d'un premier type de prise ou socle, coté véhicule, pour la recharge d'un véhicule électrique.
La figure 7, précédemment présentée, est un schéma d'un deuxième type de prise ou socle, coté véhicule, pour la recharge d'un véhicule électrique.
La figure 8, précédemment présentée, est un schéma d'un troisième type de prise ou socle, coté véhicule, pour la recharge d'un véhicule électrique.
La figure 9, précédemment présentée, est un schéma d'un quatrième type de prise ou socle, coté véhicule, pour la recharge d'un véhicule électrique.
La figure 10, précédemment présentée, est un schéma d'un premier type de prise ou socle, coté équipement d'alimentation, pour la recharge d'un véhicule électrique.
La figure 11, précédemment présentée, est un schéma d'un deuxième type de prise ou socle, coté équipement d'alimentation, pour la recharge d'un véhicule électrique.
La figure 12, précédemment présentée, est un schéma d'un troisième type de prise ou socle, coté équipement d'alimentation, pour la recharge d'un véhicule électrique.
La figure 13 est un schéma de principe de l'intégration d'une prise plug dans un circuit de recharge.
La figure 14 est un schéma de principe de l'architecture d'un dispositif selon l'invention.
La figure 15 est une représentation d'une prise plug et de son socle, en position séparés.
La figure 16 est une représentation d'une prise plug et de son socle, en position accouplés.
La figure 17 est une représentation d'un mode de réalisation d'un dispositif selon l'invention intégré sur une prise plug.
La figure 18 est une représentation de l'implantation d'un dispositif selon l'invention sur un câble de charge d'un véhicule électrique.
La figure 19 est un schéma électrique de l'implantation d'un dispositif selon l'invention sur un câble de charge d'un véhicule électrique
La figure 20 est un schéma électrique de l'implantation d'un dispositif selon l'invention dans une borne de charge d'un véhicule électrique

Sur l'ensemble des figures, les éléments similaires portent des références identiques.

### DESCRIPTION DETAILLEE DE L'INVENTION

### Architecture générale

Selon un premier aspect, l'invention concerne un dispositif 1 de détermination de l'état de santé d'une batterie d'un véhicule électrique.

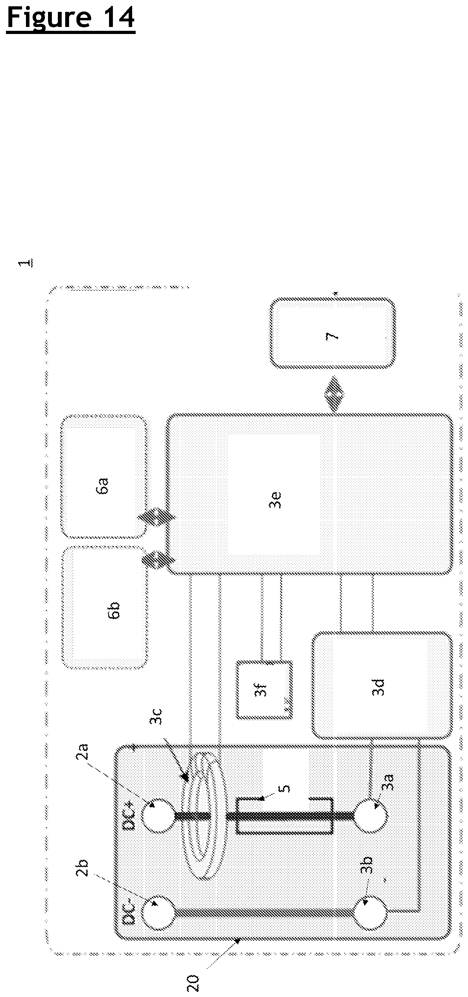

Tel que représenté sur la figure 14, le dispositif 1 peut comprendre des connecteurs 2 reliés à une prise de service plug du véhicule, et des organes de mesure 3 lors d'une charge / décharge de grandeurs électriques et/ou physiques de la batterie.

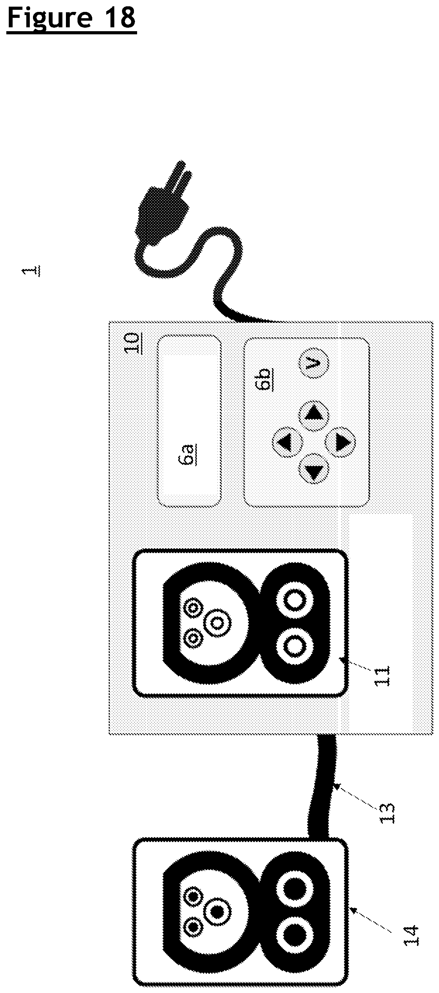

Tel que représenté sur les figures 18, 19 et 20, le dispositif 1 peut comprendre des connecteurs reliés à un organe de charge du véhicule, et des organes de mesure 3 lors d'une charge / décharge de grandeurs électriques et/ou physiques de la batterie.

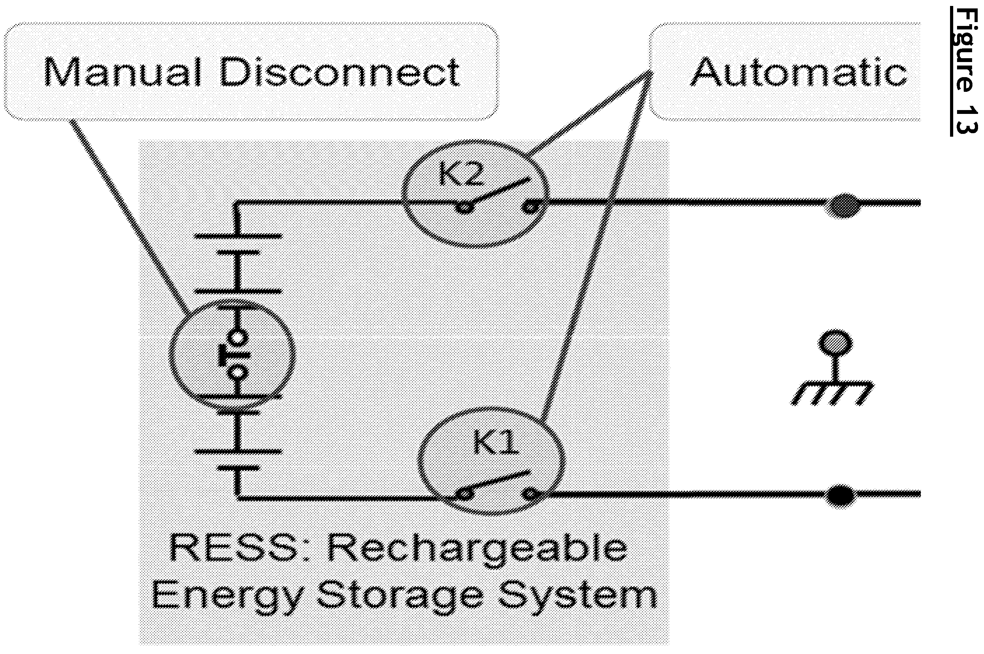

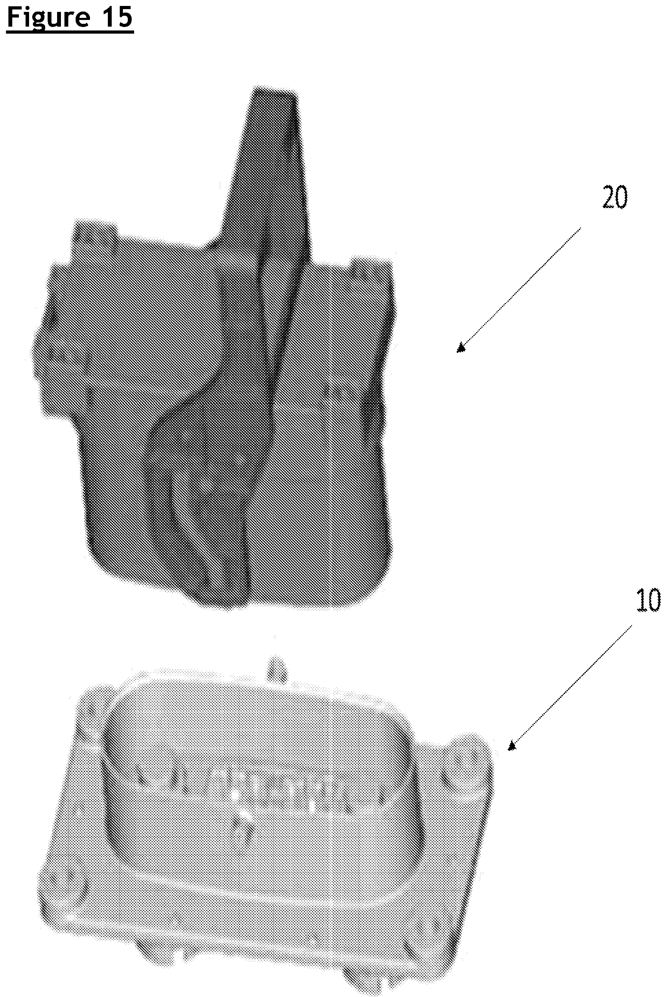

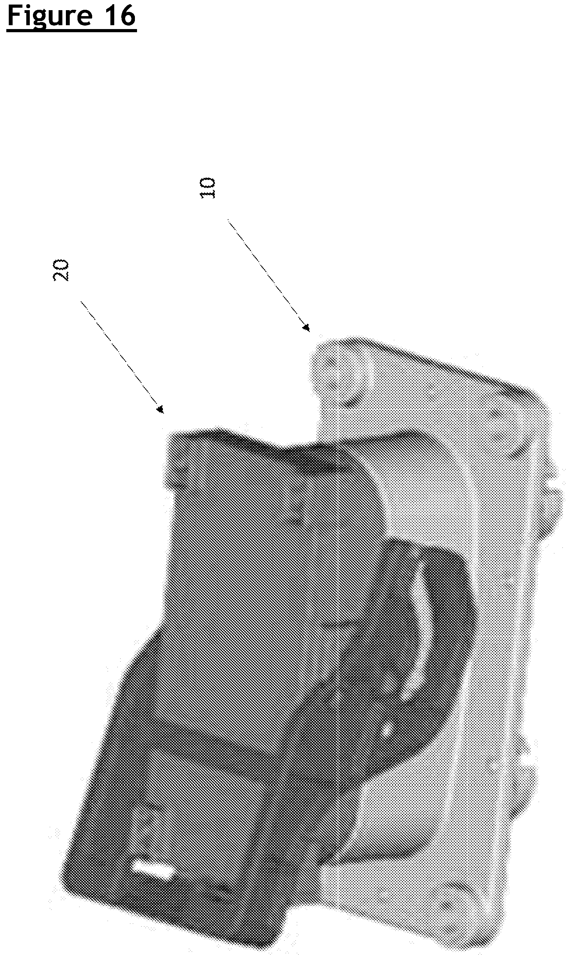

L'intégration du dispositif 1 à une prise de service plug est particulièrement avantageuse. En effet, tous les véhicules électriques avec batterie de traction disposent obligatoirement de cette prise. Traditionnellement, (comme représenté sur les figures 13, 15 et 16) le service plug est composé d'une part d'un socle 10 relié d'un côté à la batterie de traction et de l'autre coté à la partie utilisation du véhicule. D'autre part, le service plug comprend une prise 20 qui permet d'isoler électriquement la batterie de traction et de limiter ainsi le risque de choc électrique lors des opérations d'entretiens, de dépannages et dans certain cas lors d'interventions des pompiers sur un véhicule accidenté. Cette prise 20 ne peut être manipulée que par des personnes habilitées. En d'autres termes, l'intégration du dispositif 1 dans une prise 20 de service plug garantit qu'il soit connectable avec tous les véhicules indépendamment de la technologie de rechargement choisie. De plus, la prise 20 de service plug n'étant manipulable que par un personnel agréé, cela évite qu'un simple utilisateur d'un véhicule puisse manipuler un dispositif de mesure précis électriquement connecté au circuit d'alimentation. En d'autres termes, le positionnement sur une prise de service plug permet de s'affranchir des choix technologiques des systèmes de recharge et permet de garantir la sécurité des utilisateurs.

En sus, l'intégration d'organes de mesure 3 lors d'une charge / décharge de grandeurs électriques et/ou physiques de la batterie, permet de quantifier précisément et en direct, l'état de santé des batteries de motorisation embarquées des véhicules électriques, en s'affranchissant des constructeurs automobiles. En d'autres termes, le dispositif 1 selon l'invention permet à n'importe quel opérateur habilité à manipuler une prise 20 de service plug (typiquement un garagiste, ou un centre agréé de contrôle technique) d'effectuer une mesure fiable de l'état de santé de la batterie.

L'intégration du dispositif 1 à un organe de charge du véhicule est particulièrement avantageuse. En effet, cette disposition permet à un utilisateur d'évaluer l'état de santé de son véhicule lors d'une charge. En d'autres termes, l'implantation du dispositif selon l'invention sur un organe de charge permet à n'importe quel utilisateur d'évaluer la santé de la batterie. Ainsi le dispositif selon l'invention permet de s'affranchir d'une évaluation faites chez un concessionnaire ou un garagiste. Tel que cela sera décrit ci-après, par organe de charge, il est entendu un câble de charge ou une borne de charge. Tous les véhicules électriques sont rechargés via un câble. En sus, la plupart des utilisateurs de véhicule électrique possède une borne de charge qui permet une charge plus rapide et plus sécurisée qu'une charge sur le réseau électrique domestique. L'implantation du dispositif selon l'invention sur un organe de charge le rend facile d'utilisation dans la mesure où il n'est pas nécessaire de recourir à un dispositif supplémentaire (tout utilisateur de véhicule électrique possède un organe de charge) et où il n'est pas nécessaire de faire appel à un professionnel.

En sus, l'intégration d'organes de mesure 3 lors d'une charge / décharge de grandeurs électriques et/ou physiques de la batterie, permet de quantifier précisément et en direct, l'état de santé des batteries de motorisation embarquées des véhicules électriques, en s'affranchissant des constructeurs automobiles. En d'autres termes, le dispositif 1 selon l'invention permet à n'importe quel utilisateur d'effectuer une mesure fiable de l'état de santé de la batterie.

D'une manière préférentielle, les grandeurs électriques mesurées comprennent une tension électrique aux bornes de la batterie. Un courant électrique circulant dans la batterie, peut aussi faire partie des grandeurs électriques mesurées.

En outre, les grandeurs physiques mesurées peuvent comprendre une température de la batterie.

Tel que cela sera décrit ci-après, d'une manière particulièrement avantageuse, le dispositif selon l'invention mesure la tension, le courant et la température pour déterminer l'état de santé de la batterie.

Ainsi, d'une manière avantageuse, en référence à la figure 14, les organes de mesure 3 peuvent comprendre au moins deux connecteurs électriques 3a et 3b, un capteur de courant électrique 3c, un capteur de tension électrique 3d et une unité de traitement 3e configurée pour déterminer un état de santé de la batterie à partir des grandeurs électriques mesurées en mettant pour cela en œuvre le procédé qui sera décrit par la suite. De plus, les organes de mesure 3 comprennent un capteur de température 3f de la batterie ledit capteurs de température étant relié à l'unité de traitement 3e.

### Intégration à une prise de service plug

Typiquement, selon le schéma de la figure 14, les connecteurs 3a et 3b sont respectivement branchés sur les connecteurs 2a et 2b de la prise 20 de service plug. Le connecteur 3a pouvant par exemple être relié au connecteur 2a correspondant à la phase électrique. Le connecteur 3b peut être, par exemple, relié au connecteur 2b correspondant à la masse. Le capteur de tension 3d peut être un voltmètre relié aux capteurs 3a et 3b.

Le capteur de courant électrique 3c, peut être un ampèremètre à induction (effet Hall) positionné autour du connecteur 2a de la prise 20 de service plug, pour mesurer l'intensité du courant circulant dans ce connecteur 2a. Le choix d'un ampèremètre à induction permet de garantir la fiabilité de la mesure sans ajouter de capteur au sein même du circuit électrique de la prise plug. En effet, la mesure par induction se fait autour du connecteur et ne vient pas ajouter un ampèremètre en série dans le circuit électrique de la prise 20 de service plug. Ainsi, cette disposition permet de garantir le bon fonctionnement de la prise 20 même si le capteur de courant 3c tombe en panne (ce qui ne serait pas nécessairement le cas avec un capteur incorporé en série dans le circuit électrique de la prise 20 de service plug).

Tel que représenté sur la figure 14, le capteur de courant 3c, le capteur de tension 3d et le capteur de température 3f sont tous reliés à l'unité de traitement 3e. Typiquement, l'unité de traitement 3e peut être un microcontrôleur ou un microprocesseur.

Selon une disposition particulièrement avantageuse, le dispositif 1 peut comprendre un fusible 5 interposé entre l'un des connecteurs électriques 2a de la prise 20 de service plug et le capteur de tension 3d, le fusible 5 permet de protéger le dispositif 1 en cas d'un défaut lié à un court-circuit.

En outre, le dispositif 1 peut comprendre une interface homme-machine 6, pour afficher des grandeurs électriques mesurées et l'état de santé déterminé de la batterie. L'interface homme-machine 6 peut comprendre au moins un écran 6a permettant d'afficher un résultat d'une mesure opérée par au moins un capteur 3. L'écran 6a peut être déporté de sorte à ne pas être physiquement sur la prise 20 de service plug. Ainsi, l'écran 6a peut être un élément branché à la prise 20 de service plug, ou relié par une liaison sans fil. Cette disposition permet de faciliter la lisibilité sur l'écran 6a, celui-ci pouvant être conservé à portée de main / de regard d'un utilisateur, alors que la prise 20 de service plug peut être dans un endroit difficile d'accès du véhicule.

L'interface homme machine 6 peut aussi comprendre un clavier 6b permettant de piloter le dispositif.

D'une manière particulièrement avantageuse, tout comme l'écran 6a, le clavier 6b peut être déporté (i.e. être physiquement à distance de la prise plug).

En outre, selon une disposition particulièrement avantageuse, l'écran 6a et le clavier 6b peuvent être des composants d'un même ordinateur. Dans ce cas, l'ordinateur peut être un poste spécifique fourni avec la prise 20 de service plug, ou peut-être un ordinateur communiquant avec la prise 20 de service plug via un logiciel spécifique.

Le dispositif 1 peut aussi comprendre un émetteur récepteur sans fil 7, l'émetteur récepteur sans fil 7 étant préférentiellement un émetteur récepteur Wifi et/ou un émetteur récepteur Bluetooth. L'émetteur récepteur sans fil 7 peut permettre de communiquer avec des éléments du dispositif 1 qui peuvent être physiquement distants de la prise 20 de service plug, comme par exemple le clavier 6b et l'écran 6a, ou un ordinateur distant, ou un smartphone ou une tablette, comprenant le clavier 6b et l'écran 6a.

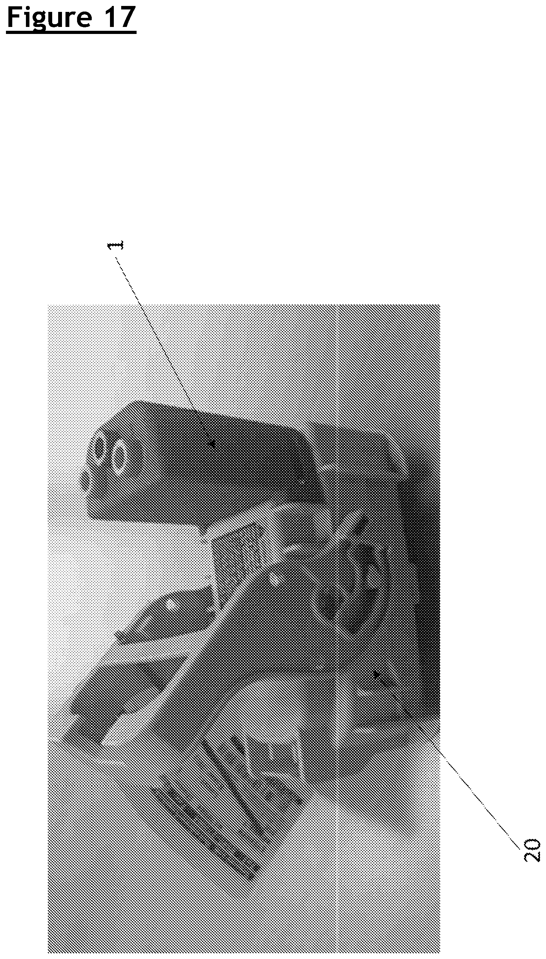

Ainsi, selon l'exemple présenté en figure 17, l'interface homme machine 6 est physiquement déportée de la prise 20 de service plug. Comme on peut l'observer sur la figure 17, cette disposition permet au dispositif 1 d'être particulièrement compact.

### Implantation sur un câble

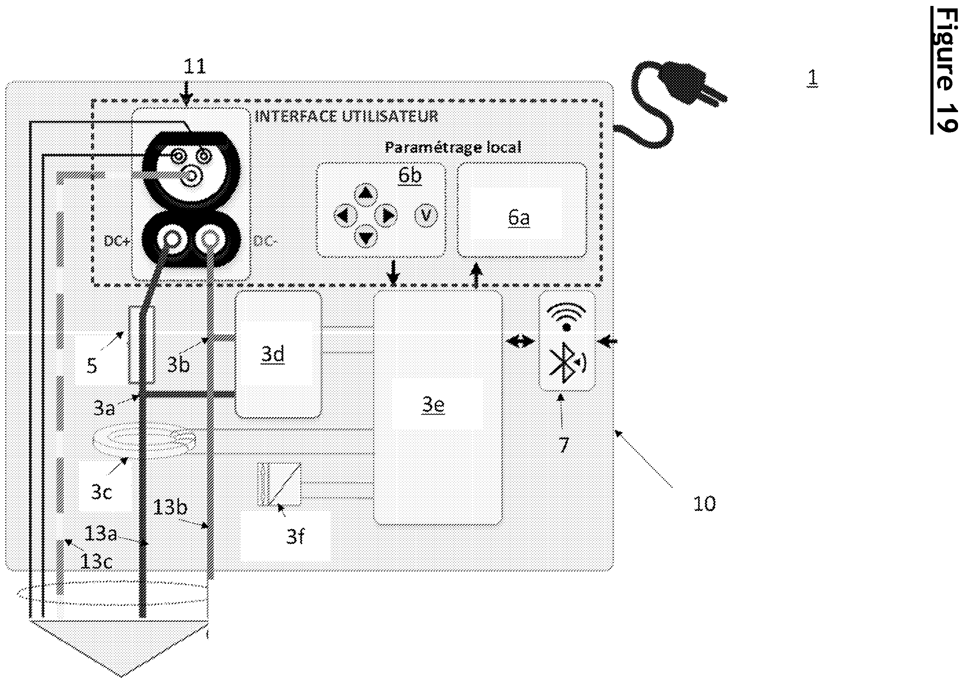

Selon un autre mode de réalisation représenté sur les figures 18 et 19, le dispositif 1 peut être connecté à un câble de charge (non représenté).

Selon un mode de réalisation préférentiel d'implantation sur le câble de charge, le dispositif 1 comprend un boitier 10 sur lequel sont visibles une prise femelle 11 complémentaire de la prise mâle du câble de charge. Il est précisé que par prise mâle du câble de charge, il est entendu la prise adaptée pour être connectée au véhicule pour le charger.

En outre, le dispositif comprend une portion de câble électrique 13 et une prise mâle 14 de charge. La prise mâle 14 est adaptée pour être connectée au véhicule pour le charger.

La connexion électrique du dispositif 1 par rapport au câble de charge et à un circuit électrique de charge reliant le câble au véhicule sera détaillé ci-après. Néanmoins, d'une manière schématique, il peut être considéré que le dispositif 1 se comporte comme une simple rallonge électrique venant s'intercaler entre le câble de charge et le véhicule.

En outre, comme on peut le voir sur la figure 19, une interface homme-machine 6 peut aussi être visible sur le boitier 10.

L'interface homme machine 6 permet d'afficher des grandeurs électriques mesurées et l'état de santé déterminé de la batterie. Selon le mode de réalisation ici présenté, l'interface homme-machine 6 comprend un écran 6a permettant d'afficher un résultat d'une mesure opérée par au moins un capteur 3. Typiquement l'écran 6a peut être un écran à cristaux liquides (aussi appelé écran LCD). L'interface homme machine 6 peut aussi comprendre un clavier 6b permettant de piloter le dispositif 1.

En sus, le dispositif 1 peut comprendre une prise électrique de connexion au réseau électrique domestique.

En référence à la figure 18, et comme indiqué précédemment, la liaison électrique entre la prise femelle 11 et la prise mâle 14 se comporte comme une rallonge électrique. Il est d'ailleurs précisé que le type de prise représenté sur les figures 18 et 19 n'est qu'un exemple, le dispositif pouvant être adapté à d'autres types de prise de charge.

La liaison électrique entre la prise femelle 13 et la prise mâle 14 comprend au moins une phase 13a, un neutre 13b et une mise à terre 13c.

Typiquement, selon le schéma de la figure 19, les connecteurs 3a et 3b sont respectivement branchés en dérivation sur la phase 13a et le neutre 13b. Le capteur de tension 3d peut être un voltmètre relié aux capteurs 3a et 3b.

Le capteur de courant électrique 3c, peut être un ampèremètre à induction (effet Hall) positionné autour de la phase 13a, pour mesurer l'intensité du courant circulant dans la phase 13a. Le choix d'un ampèremètre à induction permet de garantir la fiabilité de la mesure sans ajouter de capteur en série dans le circuit électrique de charge. En effet, la mesure par induction se fait autour de la phase 13a et ne vient pas ajouter un ampèremètre en série dans le circuit électrique de charge. Ainsi, cette disposition permet de garantir le bon fonctionnement de charge même si le capteur de courant 3c tombe en panne (ce qui ne serait pas nécessairement le cas avec un capteur incorporé en série avec la phase 13a).

Tel que représenté sur la figure 19, le capteur de courant 3c, le capteur de tension 3d et le capteur de température 3f sont tous reliés à l'unité de traitement 3e. Typiquement, l'unité de traitement 3e peut être un microcontrôleur ou un microprocesseur.

Selon une disposition particulièrement avantageuse, le dispositif 1 peut comprendre un fusible 5 interposé sur la phase 13a entre la prise femelle 11 et le capteur de tension 3d, le fusible 5 permet de protéger le dispositif 1 en cas d'un défaut lié à un court-circuit.

Le dispositif 1 peut aussi comprendre un émetteur récepteur sans fil 7, l'émetteur récepteur sans fil 7 étant préférentiellement un émetteur récepteur Wifi et/ou un émetteur récepteur Bluetooth. L'émetteur récepteur sans fil 7 peut permettre de communiquer avec des éléments du dispositif 1 qui peuvent être physiquement distants du câble de charge 30, comme par exemple un ordinateur distant, ou un smartphone ou une tablette.

### Implantation dans une borne de charge

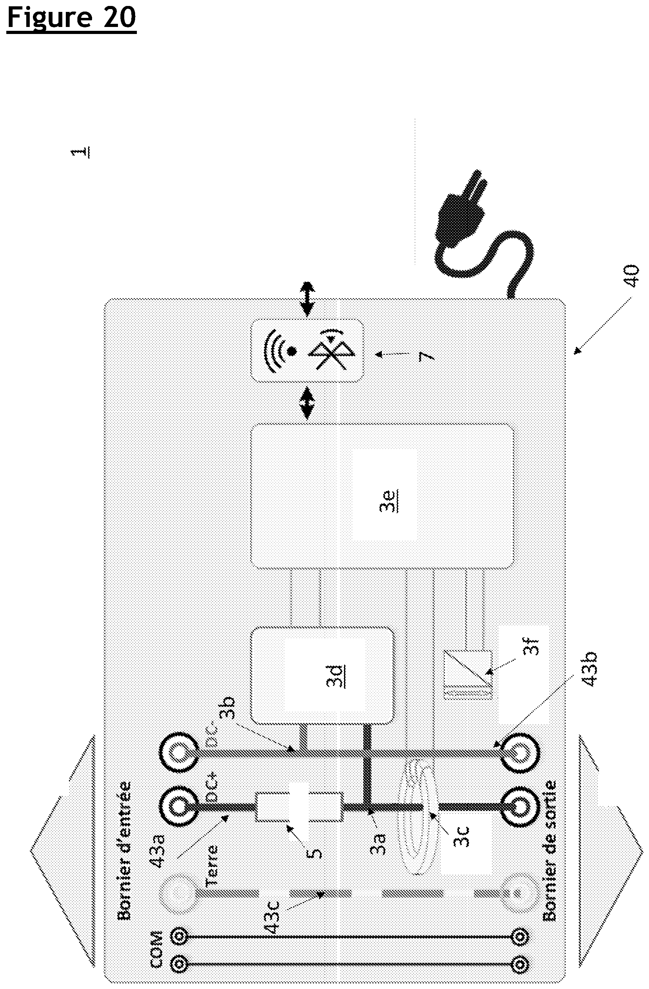

Selon un autre mode de réalisation représenté sur la figure 20, le dispositif 1 peut être implanté dans une borne de charge 40.

La borne de charge 40 comprend au moins une phase 43a, un neutre 43b et une mise à terre 43c.

Typiquement, selon le schéma de la figure 20, les connecteurs 3a et 3b sont respectivement branchés en dérivation sur la phase 43a et le neutre 43b. Le capteur de tension 3d peut être un voltmètre relié aux capteurs 3a et 3b.

Le capteur de courant électrique 3c, peut être un ampèremètre à induction positionné autour de la phase 43a, pour mesurer l'intensité du courant circulant dans la phase 43a. Le choix d'un ampèremètre à induction permet de garantir la fiabilité de la mesure sans ajouter de capteur en série au sein du circuit électrique de charge. En effet, la mesure par induction se fait autour de la phase 43a et ne vient pas ajouter un ampèremètre en série dans le circuit électrique de charge. Ainsi, cette disposition permet de garantir le bon fonctionnement de la charge même si le capteur de courant 3c tombe en panne (ce qui ne serait pas nécessairement le cas avec un capteur incorporé en série avec la phase 43a).

Tel que représenté sur la figure 20, le capteur de courant 3c, le capteur de tension 3d et le capteur de température 3f sont tous reliés à l'unité de traitement 3e. Typiquement, l'unité de traitement 3e peut être un microprocesseur.

Selon une disposition particulièrement avantageuse, le dispositif 1 peut comprendre un fusible 5 interposé sur la phase 43a entre la prise femelle 11 et le capteur de tension 3d, le fusible 5 permet de protéger le dispositif 1 d'une surtension.

Le dispositif 1 peut aussi comprendre un émetteur récepteur sans fil 7, l'émetteur récepteur sans fil 7 étant préférentiellement un émetteur récepteur Wifi et/ou un émetteur récepteur Bluetooth. L'émetteur récepteur sans fil 7 peut permettre de communiquer avec des éléments du dispositif 1 qui peuvent être physiquement distants de la borne 40.

En sus, selon ce mode de réalisation, le dispositif 1 comprend une interface homme-machine déportée. Par déportée, il est entendu que l'interface homme machine n'est pas physiquement présente dans la borne 40. Typiquement, l'interface homme machine peut être reliée au reste du dispositif 1 via les moyens de connexion sans fil 7. L'interface homme machine peut être un terminal comprenant un clavier et un écran ou peut être intégrée dans un ordinateur personnel. Dans le cas d'une intégration dans un ordinateur personnel, un logiciel spécifique permet d'afficher l'interface home machine et permet de communiquer avec le reste du dispositif 1.

En sus, le dispositif 1 peut comprendre une prise électrique de connexion au réseau électrique domestique.

### Procédé de détermination de l'état de santé d'une batterie

Selon un deuxième aspect, l'invention concerne un procédé de détermination de l'état de santé d'une batterie de motorisation d'un véhicule électrique, pouvant être implémenté par un dispositif 1 selon l'invention.

Selon une définition générale, le procédé comprend la mesure d'une grandeur électrique et / ou physique de la batterie lors d'une charge ou décharge de la batterie, et comprend la comparaison de ladite grandeur mesurée avec une grandeur de référence déterminée préalablement.

Plus précisément, le procédé peut comprendre les étapes suivantes :
(a) mesure d'un ensemble de grandeurs physiques et électriques de la batterie en un point à courant nul et après un temps de relaxation prédéterminé ;
(b) application d'un échelon de courant de charge sur la batterie et mesure d'un ensemble de grandeurs électriques et physiques de la batterie ;
(c) répétition de l'étape (b) pour différentes valeurs de courant durant un intervalle de temps prédéterminé pour obtenir un échantillon statistique pour un état de charge prédéterminé ;
(d) répétition des étapes (b) et (c) pour différents états de charge de la batterie, pour obtenir une distribution statistique de l'ensemble de grandeurs électriques mesuré à différents états de charge ;
(f) Calcul d'une distribution statistique d'un état de santé de la batterie, à partir de la distribution statistique obtenue à l'étape (d).

Par grandeur de référence préalablement déterminée, il est entendu des données de calibration obtenues préalablement, ou des données constructeurs.

D'une manière préférentielle, le procédé selon l'invention est exécuté en ayant une connaissance préalable de l'architecture de la batterie (connexion des cellules, nombre de cellules, etc.) et des données de calibration obtenues préalablement sur les cellules qui composent la batterie du véhicule. Il est précisé que les données de calibration sont des données sur les caractéristiques initiales de la batterie, notamment la quantité d'énergie stockée dans la batterie et sa résistance interne.

### Détails de l'étape (a)

Comme indiqué précédemment, l'étape (a) consiste en la mesure d'un ensemble de grandeurs physiques et électriques de la batterie à courant nul et après un temps de relaxation prédéterminé.

Il est précisé que par « temps de relaxation », il est entendu un temps de repos de la batterie durant lequel la batterie n'est pas sollicitée que ce soit en charge ou en décharge.

D'une manière avantageuse, les grandeurs physiques et électriques de la batterie mesurées à l'étape (a) peuvent être choisies parmi la tension, le courant et la température, ou une combinaison de ces grandeurs.

En outre, l'étape (a) peut comprendre une estimation d'une température interne de la batterie en utilisant un modèle thermique et une mesure de température.

Suite à cette estimation, l'étape (a) peut aussi comprendre une détermination d'un état de charge apparent de la batterie par traitement d'une tension mesurée et de la température interne estimée ou mesurée.

### Détails de l'étape (b)

Comme indiqué précédemment, l'étape (b) consiste en l'application d'un échelon de courant de charge sur la batterie et mesure d'un ensemble de grandeurs électriques et physiques de la batterie.

D'une manière préférentielle, les grandeurs physiques et électriques de la batterie mesurées à l'étape (b) peuvent être choisies parmi la tension, le courant et la température, ou une combinaison de ces grandeurs.

En sus, l'étape (b) peut comprendre une estimation d'une distribution de la température interne de la batterie en utilisant un modèle thermique et un ensemble de température mesuré lors de l'étape (a)

Suite à cette estimation, l'étape (b) peut comprendre un recalage de l'ensemble des mesures par rapport à la distribution de température estimée.

Puis, l'étape (b) peut comprendre un calcul d'une résistance apparente de la batterie.

Suite à ce calcul, l'étape (b) peut comprendre une estimation d'une distribution statistique d'une résistance et d'un courant de la batterie ou de chaque cellule, connaissant une résistance théorique de la batterie lorsque son état de santé est à 100% et connaissant la résistance apparente calculée. Si la batterie comprend plusieurs cellules, l'étape (b) peut comprendre le calcul de paramètres de tension, de courant et de résistance interne pour chaque cellule, pour obtenir une distribution statistique par cellule.

### Etape (c)

Comme indiqué précédemment, l'étape (c) consiste en la répétition de l'étape (b) pour différentes valeurs de courant durant un intervalle de temps prédéterminé pour obtenir un échantillon statistique pour un état de charge prédéterminé.

L'obtention d'un échantillon statistique permet d'écarter d'éventuelles aberrations liées à des mesures discrètes. L'objectif de cette étape est de faire ressortir une corrélation entre les valeurs de temps et de courant avec une très faible variation d'état de charge (inférieure ou égale à 1%).

### Etape (d)

Comme indiqué précédemment l'étape (d) consiste principalement en la répétition des étapes (b) et (c) pour différents états de charges de la batterie, pour obtenir une distribution statistique pour différents états de charges.

D'une manière particulièrement avantageuse, l'état de charge peut être calculé par intégration coulométrique. Cette disposition permet de calculer une charge et donc une variation d'état de charge, en utilisant uniquement la mesure du courant en fonction du temps.

En outre, selon un mode de réalisation avantageux, les différents états de charges sont par exemple des paliers de 10%. Il est précisé que la variation des états de charge est directement liée aux capacités de la borne de recharge.

### Etape (e)

Selon une disposition particulière, le procédé peut comprendre une étape (e) intermédiaire des étapes (d) et (f).

L'étape (e) comprend un calcul de distributions statistiques de l'état de santé de chaque cellule de la batterie, à partir d'une distribution statistique par cellule des paramètres de tension obtenue lorsque l'étape (b) a été exécutée pour chaque cellule. Il est précisé que l'état de santé peut être défini comme la capacité de la batterie (ou de la cellule) en fonction du temps divisée par la capacité nominale de la batterie (ou de la cellule). Il est aussi précisé que la capacité en fonction du temps correspond à la capacité totale de la batterie le jour du test, lors de l'évaluation du SOH (state of health - ce qui signifie l'état de santé). La capacité nominale correspond à la capacité totale de la batterie lorsque celle-ci est neuve.

Ainsi, dans le cas d'une batterie possédant plusieurs cellules, cette étape permet de cartographier, de déterminer, l'état de santé de chaque cellule.

### Etape (f)

Comme indiqué précédemment, l'étape (f) consiste principalement en un calcul d'une distribution statistique d'un état de santé de la batterie, à partir de la distribution statistique obtenues à l'étape (d). En d'autres termes, l'étape (f) consiste à estimer différents paramètres de la batterie, pour différents états de charge, ce qui permet une estimation précise de l'état de santé de la batterie.

Si la batterie analysée possède plusieurs cellules et que l'étape (e) a été réalisée, alors, l'étape (f) peut être réalisée en utilisant les distributions statistiques des états de santé de chaque cellule déterminée à l'étape (e), et en utilisant une configuration électrique connue de la batterie.

## Revendications

1. Procédé de détermination de l'état de santé d'une batterie de motorisation d'un véhicule électrique, le procédé étant implémenté par un dispositif qui comprend des organes de mesure, lors d'une charge/décharge de la batterie, de grandeurs physiques et électriques de la batterie et une unité de traitement configurée pour mettre en œuvre au moins les étapes suivantes :
(a) mesure d'un ensemble de grandeurs physiques et électriques de la batterie en un point à courant nul et après un temps de relaxation prédéterminé ;
(b) application d'un échelon de courant de charge sur la batterie et mesure d'un ensemble de grandeurs électriques et physiques de la batterie ;
(c) répétition de l'étape (b) pour différentes valeurs de courant durant un intervalle de temps prédéterminé pour obtenir un échantillon statistique pour un état de charge prédéterminé ;
(d) répétition des étapes (b) et (c) pour différents états de charges de la batterie, pour obtenir une distribution statistique de l'ensemble de grandeurs électriques mesurées à différents états de charge ;
(f) Calcul d'une distribution statistique d'un état de santé de la batterie, à partir de la distribution statistique obtenue à l'étape (d).

2. Procédé selon la revendication 1, dans lequel les grandeurs physiques et électriques de la batterie mesurées à l'étape (a) et à l'étape b) sont choisies parmi la tension, le courant et la température, ou une combinaison de ces grandeurs.

3. Procédé selon la revendication 2, dans lequel l'étape (a) comprend une estimation d'une température interne de la batterie en utilisant un modèle thermique et une mesure de température.

4. Procédé selon les revendications 2 et 3 en combinaison, dans lequel l'étape (a) comprend une détermination d'un état de charge apparent de la batterie par traitement d'une tension mesurée et de la température interne estimée.

5. Procédé selon la revendication 2, dans lequel l'étape (b) comprend une estimation d'une distribution de la température interne de la batterie en utilisant un modèle thermique et une mesure de température.

6. Procédé selon la revendication 5, dans lequel l'étape (b) comprend un recalage de l'ensemble des mesures par rapport à la distribution de température estimée.

7. Procédé selon l'une quelconque des revendications 2 à 6, dans lequel l'étape (b) comprend un calcul d'une résistance apparente de la batterie.

8. Procédé selon la revendication 7, dans lequel l'étape (b) comprend une estimation d'une distribution statistique connaissant une résistance théorique de la batterie lorsque son état de santé est à 100% et connaissant la résistance apparente calculée.

9. Procédé selon la revendication 8, dans lequel si la batterie comprend plusieurs cellules, l'étape (b) comprend le calcul de paramètres de tension, de courant et de résistance interne pour chaque cellule, pour obtenir une distribution statistique par cellule.

10. Procédé selon la revendication 9, comprenant une étape (e) intermédiaire des étapes (d) et (f), l'étape (e) comprenant un calcul de distributions statistiques de l'état de santé de chaque cellule de la batterie, à partir de la distribution statistique par cellule des paramètres de tension.

11. Procédé selon la revendication 10, dans lequel l'étape (f) est réalisée en utilisant les distributions statistiques des états de santé de chaque cellule calculés à l'étape (e), et en utilisant une configuration électrique connue de la batterie.

12. Procédé selon l'une quelconque des revendications 1 à 11, dans lequel l'état de charge est calculé par intégration coulométrique.

13. Dispositif (1) de détermination de l'état de santé d'une batterie d'un véhicule électrique, comprenant des organes de mesure (3), lors d'une charge / décharge de la batterie, de grandeurs électriques et/ou physiques de la batterie, **caractérisé en ce que** les organes de mesure (3) comprennent au moins deux connecteurs électriques (3a, 3b), un capteur de courant électrique (3c), un capteur de tension électrique (3d) et une unité de traitement (3e) configurée pour mettre en œuvre le procédé selon l'une des revendications 1 à 12.

14. Prise de service plug pour véhicule électrique, comprenant un socle (10) relié d'un côté à une batterie du véhicule électrique et de l'autre coté à une partie utilisation du véhicule électrique, une prise (20) manipulable par un opérateur qui permet d'isoler électriquement la batterie, la prise de service plug comprenant en outre un dispositif (1) selon la revendication 13.

15. Câble ou borne de charge de véhicule électrique comprenant un dispositif (1) selon la revendication 13.

## Patentansprüche

1. Verfahren zur Bestimmung des Gesundheitszustands einer Antriebsbatterie eines Elektrofahrzeugs, wobei das Verfahren durch eine Vorrichtung implementiert wird, die Organe zum Messen physikalischer und elektrischer Größen der Batterie beim Laden/Entladen der Batterie und eine Verarbeitungseinheit umfasst, die so konfiguriert ist, dass sie mindestens die folgenden Schritte durchführt:
(a) Messen einer Reihe von physikalischen und elektrischen Größen der Batterie an einem Nullstrompunkt und nach einer vorbestimmten Entspannungszeit;
(b) Anlegen einer Ladestromstufe an die Batterie und Messen einer Reihe von elektrischen und physikalischen Größen der Batterie;
(c) Wiederholen des Schritts (b) für verschiedene Stromwerte während eines vorbestimmten Zeitintervalls, um eine statistische Stichprobe für einen vorbestimmten Ladezustand zu erhalten;
(d) Wiederholen der Schritte (b) und (c) für verschiedene Ladezustände der Batterie, um eine statistische Verteilung aller bei verschiedenen Ladezuständen gemessenen elektrischen Größen zu erhalten;
(f) Berechnen einer statistischen Verteilung eines Gesundheitszustands der Batterie anhand der in Schritt (d) erhaltenen statistischen Verteilung.

2. Verfahren nach Anspruch 1, wobei die in Schritt (a) und Schritt b) gemessenen physikalischen und elektrischen Größen der Batterie aus Spannung, Strom und Temperatur oder einer Kombination dieser Größen ausgewählt sind.

3. Verfahren nach Anspruch 2, wobei Schritt (a) das Schätzen einer Innentemperatur der Batterie unter Verwendung eines thermischen Modells und einer Temperaturmessung umfasst.

4. Verfahren nach Anspruch 2 und 3 in Kombination, wobei der Schritt (a) das Bestimmen eines scheinbaren Ladezustands der Batterie durch Verarbeitung einer gemessenen Spannung und der geschätzten Innentemperatur umfasst.

5. Verfahren nach Anspruch 2, wobei Schritt (b) ein Schätzen einer Verteilung der Innentemperatur der Batterie unter Verwendung eines thermischen Modells und einer Temperaturmessung umfasst.

6. Verfahren nach Anspruch 5, wobei der Schritt (b) das Neukalibrieren aller Messungen in Bezug auf die geschätzte Temperaturverteilung umfasst.

7. Verfahren nach einem der Ansprüche 2 bis 6, wobei der Schritt (b) das Berechnen eines Scheinwiderstands der Batterie umfasst.

8. Verfahren nach Anspruch 7, wobei Schritt (b) das Schätzen einer statistischen Verteilung umfasst, die einen theoretischen Widerstand der Batterie kennt, wenn ihr Gesundheitszustand 100 % beträgt, und die den berechneten Scheinwiderstand kennt.

9. Verfahren nach Anspruch 8, wobei, wenn die Batterie mehrere Zellen umfasst, der Schritt (b) das Berechnen von Spannungs-, Strom- und Innenwiderstandsparametern für jede Zelle umfasst, um eine statistische Verteilung pro Zelle zu erhalten.

10. Verfahren nach Anspruch 9, umfassend einen Zwischenschritt (e) zwischen den Schritten (d) und (f), wobei der Schritt (e) das Berechnen statistischer Verteilungen des Gesundheitszustands jeder Zelle der Batterie anhand der statistischen Verteilung der Spannungsparameter pro Zelle umfasst.

11. Verfahren nach Anspruch 10, wobei Schritt (f) unter Verwendung der in Schritt (e) berechneten statistischen Verteilungen der Gesundheitszustände jeder Zelle und unter Verwendung einer bekannten elektrischen Konfiguration der Batterie durchgeführt wird.

12. Verfahren nach einem der Ansprüche 1 bis 11, wobei der Ladezustand durch coulometrische Integration berechnet wird.

13. Vorrichtung (1) zur Bestimmung des Gesundheitszustands einer Batterie eines Elektrofahrzeugs, umfassend Organe (3) zum Messen elektrischer und/oder physikalischer Größen der Batterie beim Laden/Entladen der Batterie, **dadurch gekennzeichnet, dass** die Messorgane (3) mindestens zwei elektrische Steckverbinder (3a, 3b), einen elektrischen Stromsensor (3c), einen elektrischen Spannungssensor (3d) und eine Verarbeitungseinheit (3e) umfassen, die so konfiguriert ist, dass sie das Verfahren nach einem der Ansprüche 1 bis 12 durchführt.

14. Service-Steckdose für Elektrofahrzeug, umfassend einen Sockel (10), der auf der einen Seite mit einer Batterie des Elektrofahrzeugs und auf der anderen Seite mit einem Nutzungsteil des Elektrofahrzeugs verbunden ist, und einen von einem Bediener betätigbaren Stecker (20), der es ermöglicht, die Batterie elektrisch zu isolieren, wobei der Servicestecker ferner eine Vorrichtung (1) nach Anspruch 13 umfasst.

15. Ladekabel oder Ladestation für Elektrofahrzeuge, umfassend eine Vorrichtung (1) nach Anspruch 13.

## Claims

1. Method for determining the state of health of an electric vehicle motor battery, the method being implemented by a device that includes means for measuring, during charging/discharging of the battery, physical and electrical parameters of the battery, and a processing unit configured to implement at least the following steps:
(a) measuring a set of physical and electrical quantities of the battery at a zero current point and after a predetermined relaxation time;
(b) applying a step load current to the battery and measuring a set of electrical and physical quantities of the battery;
(c) repeating step (b) for different current values during a predetermined time interval to obtain a statistical sample for a predetermined state of charge;
(d) repeating steps (b) and (c) for different states of charge of the battery, to obtain a statistical distribution of the set of electrical quantities measured at different states of charge;
(f) calculating a statistical distribution of a state of health of the battery from the statistical distribution obtained in step (d).

2. Method according to claim 1, wherein the physical and electrical quantities of the battery measured in step (a) and step (b) are selected from voltage, current and temperature, or a combination of these quantities.

3. Method according to claim 2, wherein step (a) comprises estimating an internal temperature of the battery using a thermal model and a temperature measurement.

4. Method according to claims 2 and 3 in combination, wherein step (a) comprises determining an apparent state of charge of the battery by processing a measured voltage and the estimated internal temperature.

5. Method according to claim 2, wherein step (b) comprises estimating a distribution of the internal temperature of the battery using a thermal model and a temperature measurement.

6. Method according to claim 5, wherein step (b) comprises recalibrating all measurements relative to the estimated temperature distribution.

7. Method according to any of claims 2 to 6, wherein step (b) comprises calculating an apparent resistance of the battery.

8. Method according to claim 7, wherein step (b) comprises estimating a statistical distribution knowing a theoretical resistance of the battery when its state of health is 100% and knowing the calculated apparent resistance.

9. Method according to claim 8, wherein if the battery comprises several cells, step (b) comprises calculating voltage, current and internal resistance parameters for each cell, to obtain a statistical distribution per cell.

10. Method according to claim 9, comprising an intermediate step (e) between steps (d) and (f), step (e) comprising calculating statistical distributions of the state of health of each cell of the battery, based on the statistical distribution per cell of the voltage parameters.

11. Method according to claim 10, wherein step (f) is performed using the statistical distributions of the health states of each cell calculated in step (e), and using a known electrical configuration of the battery.

12. Method according to any of claims 1 to 11, wherein the state of charge is calculated by coulometric integration.

13. Device (1) for determining the state of health of an electric vehicle battery, comprising measuring elements (3) for measuring electrical and/or physical quantities of the battery during charging/discharging of the battery, **characterised in that** the measuring elements (3) comprise at least two electrical connectors (3a, 3b), an electric current sensor (3c), an electric voltage sensor (3d) and a processing unit (3e) configured to implement the method according to one of claims 1 to 12.

14. Service plug for an electric vehicle, comprising a base (10) connected on one side to an electric vehicle battery and on the other side to a user part of the electric vehicle, a plug (20) that can be operated by an operator to electrically isolate the battery, the service plug further comprising a device (1) according to claim 13.

15. Electric vehicle charging cable or terminal comprising a device (1) according to claim 13.
